# EUROPEAN PATENT APPLICATION

(11) **EP 2 278 625 A1**
(43) Date of publication of application: **26.01.2011**
(21) Application number: 09009994.6
(22) Date of filing: 24.07.2009
(51) Int. Cl.: H01L 31/0336, H01L 31/18

(54) **Method and apparatus for deposition of a layer of an Indium Chalcogenide onto a substrate**

(71) Applicant: centrotherm photovoltaics AG, 89143 Blaubeuren (DE)
(72) Inventor: Kampmann, Andreas, Dr., 89073 Ulm (DE); Kötschau, Immo, Dr., 89134 Blaustein (DE); Schmid, Dieter, Dr., 72764 Reutlingen (DE); Sheel, David William, Ormskirk Lancashire L39 5EP (GB)
(74) Representative: Heyerhoff, Markus

(57) **Abstract**

Method for depositing a layer of an indium chalcogenide (7; 17a, 17b; 27a, 27b) onto a substrate (1), the method comprising the steps of providing an indium source (3; 77a, 77b; 83) in a reaction zone (8; 18a, 18b), providing a gaseous source (9; 79a, 79b; 85) of a chalcogen in the reaction zone (8; 18a, 18b), heating the substrate (1), and thereby in a reaction zone (8; 18a, 18b) converting at a pressure of approximately atmospheric ambient pressure indium originating from the indium source (3; 77a, 77b; 83) and the chalcogen originating from the source (9; 79a, 79b; 85) of a chalcogen to an indium chalcogenide (7; 17a, 17b; 27a, 27b) being deposited onto the surface (2) of the substrate (1), as well as apparatus for carrying out said method.

## Description

The present invention relates to a method for depositing a layer of an indium chalcogenide onto a substrate and to an apparatus for carrying out the method according to the preamble of claim 16 as well as to a solar cell according to the preamble of claim 14.

Indium chalcogenide layers, sometimes also referred to as indium chalcogenide films, may be used in several applications, particularly in the field of semiconductor technology. For the purpose of the present invention indium chalcogenides are indium compounds comprising a chalcogen, i.e. elements of group 16 of the periodic table of elements like oxygen, sulphur, selenium etc. For example, indium sulphide, indium selenide or indium oxide and mixtures thereof are such indium chalcogenides. For the purposes of the present invention, the term chalcogenide is also defined as including oxide material which has been at least partly converted to hydroxide.

In particular, indium chalcogenides have been investigated in recent years in connection with solar cells of the second generation, also referred to as compound thin film solar cells. Such solar cells usually comprise a substrate for structurally supporting the solar cell, e.g. a glass substrate, a back contact forming metal layer arranged upon the glass substrate, an absorber layer formed on the metal layer for example by copper indium selenide (CIS), copper indium gallium selenide (CIGS) or copper indium gallium sulphur selenide (CIGSSe), and a buffer layer deposited onto the absorber layer for which cadmium sulphide is widely used. Further on, the buffer layer is covered by a transparent conducting material like zinc oxide. The different layers can be formed by evaporation under vacuum conditions. However, this technique is not well-suited for low cost production at an industrially scale.

This problem has been partly addressed by the invention described in WO 2009/033674. It provides for a thermal conversion of metallic precursor layers into a semiconducting absorber layer like CIGS at approximately atmospheric pressure. In this way absorber layers can be produced in an industrial scale at low complexity. It even allows an inline production of absorber layers.

However, thin film solar cells also require a buffer layer. As the deposition of cadmium sulphide as buffer layer is problematic with respect to environmental risks and the prohibition of the usage of cadmium in certain countries, alternative materials have been investigated. Indium chalcogenides like indium sulphide have proven as promising alternatives to cadmium sulphide. Indium chalcogenide layers may be applied by chemical bath deposition. This method, however, requires a quite long processing time and produces contaminated wastewater which requires costly special treatment. Indium chalcogenide deposition by atomic layer deposition (ALD) or ion layer gas reaction (ILGAR) also requires long processing times. Physical vapour deposition (PVD) and sputtering are performed under vacuum and are consequently quite elaborate and costly. This is also the case for metal organic chemical vapour deposition (MOCVD).

Against this background, the present invention is based on the problem to provide a low-complexity method to deposit an indium chalcogenide layer onto a substrate.

This problem is solved by a method having the features of claim 1.

Furthermore, the invention is based on the problem to provide an apparatus for carrying out said method.

This problem is solved by an apparatus according to claim 16.

Moreover, it is a further object of the invention to provide a solar cell that can be produced at an industrial scale at favourable cost.

This problem is solved by a solar cell according to claim 14.

Respective dependent claims relate to advantageous developments.

The method according to the invention is based on the concept of providing an indium source in a reaction zone, providing a gaseous source of a chalcogen in the reaction zone, heating the substrate and thereby in the reaction zone converting at a pressure of approximately atmospheric ambient pressure indium originating from the indium source and chalcogen originating from the source of a chalcogen to an indium chalcogenide being deposited onto a surface of a substrate.

For the purpose of the present invention, reaction zone means an area, in which conditions like temperature etc. are such that indium originating from an indium source located in the reaction zone and chalcogen originating from a source of chalcogen located in the reaction zone can be converted into indium chalcogenide and such that said indium chalcogenide can be deposited onto the surface of the substrate. In most cases the reaction zone will therefore be formed in the near neighbourhood of the substrate and may include the surface of the substrate itself. Furthermore, substrate means in principle anything an indium chalcogenide layer can be deposited on. It might for example be a glass substrate with or without any layers deposited or formed before the deposition of the indium chalcogenide.

For the purpose of the present invention approximately atmospheric ambient pressure means that the conversion of indium originating from the indium source and chalcogen originating from the source of a chalcogen to an indium chalcogenide takes place under a pressure having nearly the same pressure value as the atmospheric ambient pressure. The values might slightly differ due to gas flows within or out of the reactor or other effects. But in each case the reactor is not in any way evacuated and the pressure value at the substrate is not more than 50 mbar lower than the atmospheric ambient pressure. However, it might be more than 50 mbar higher.

Heating might be performed in the reaction zone or before the substrates are fed into the reaction zone. In the latter case the substrates have to be heated in such that their temperature at the time when they reach the reaction zone is still high enough to enable the described conversion in the reaction zone.

The method according to the invention reduces complexity of indium chalcogenide deposition, as no vacuum is needed and as processing time is short as compared to chemical bath deposition. Furthermore, the method can be applied in inline production lines.

It shall be mentioned that instead of a gaseous source of a chalcogen also such a liquid or solid source of a chalcogen can be provided within the reaction zone that said liquid or solid source of a chalcogen is converted directly into an indium chalcogenide without being previously transformed into gaseous phase. Compared to providing, in accordance with the method according to the invention, a gaseous source of a chalcogen within the reaction zone, this is, however, less advantageous.

In a preferred embodiment of the method according to the invention the indium chalcogenide to be deposited is selected from a group consisting of indium sulphide., indium selenide and indium oxide and the gaseous source of a chalcogen correspondingly provides a gaseous source of a chalcogen selected from a group consisting of sulphur, tellurium, selenium and oxygen. These materials have proven themselves. In an especially preferred embodiment, indium sulphide is deposited and the gaseous source of a chalcogen correspondingly provides a gaseous source of sulphur. In each embodiment the gaseous source can be one ore more compounds providing the respective chalcogen.

In an advantageous embodiment the substrate is heated to a temperature between 130°C and 380°C, preferably to a temperature between 230°C and 330°C.

Preferably, the substrate is moved during the indium chalcogenide is deposited, as it has turned out that in this way the homogeneity of the deposited indium chalcogenide layer can be improved.

In an advantageous embodiment several indium chalcogenide layers are deposited sequentially. The resulting several sublayers form together the final layer having the desired thickness. In doing so, properties of the deposited indium chalcogenide layer can be improved. Furthermore, it allows a high throughput in manufacturing of thin film solar cells, for example, particularly in connection with inline production lines.

Using the method according to the invention indium chalcogenide layers can be deposited at significant higher growth rates as it is possible using other techniques like vacuum MOCVD. In a preferred embodiment therefore the indium chalcogenide layer is deposited at a growth rate between 1 and 60 nm/s, especially preferred at a growth rate greater than 5 nm/s.

In a preferred embodiment of the invention the substrate is preheated before entering the reaction zone or even before entering an apparatus for carrying out the method according to the invention. The latter is especially advantageous for an inline production, for example. Preheating might be performed in such that on entering the reaction zone the temperature of the substrates is still high enough to enable the described conversion of indium and a chalcogen into an indium chalcogenide, so that no further heating of the substrates needs to be done. Or preheating might be performed in such that an additional heating within the reaction zone is necessary. In an embodiment of the invention according to the latter case, such an additional heating is performed in order to enable the desired conversion of indium originating from the indium source and the chalcogen originating from the source of a chalcogen to an indium chalcogenide.

In one embodiment of the method according to the invention the indium source is provided in the reaction zone by depositing an indium comprising compound, preferably indium oxide, onto the surface of the substrate and arranging the substrate at least partly in the reaction zone. Said indium comprising compound might be deposited onto the substrate by sputtering or chemical vapour deposition. In particular, the indium comprising compound might be itself an indium chalcogenide which has been previously deposited onto the substrate by the method according to the invention. In case of using indium oxide as indium source, another indium chalcogenide than indium oxide will be formed by applying the method according to the invention. For example, a gaseous source of sulphur, preferably hydrogen sulphide, might be fed into the reaction zone and in this way be provided therein. In this case indium originating for the indium oxide and sulphur originating from the gaseous source of sulphur would be converted into indium sulphide being deposited onto the surface of the substrate.

In an alternative embodiment of the method according to the invention a gaseous mixture comprising a carrier gas, the indium source and the chalcogen source is provided in the reaction zone. Preferably an inert gas is used as carrier gas; especially preferred is the usage of nitrogen or argon gas.

The gaseous mixture is preferably delivered to the substrate to be coated in a laminar flow. In this way the homogeneity of the deposited indium chalcogenide layers can be improved.

Until reaching the reaction zone, the gaseous mixture is advantageously kept at a temperature chosen such that gas phase reaction of the gaseous mixture is sufficiently controlled. That means that the gaseous mixture is kept at a temperature such that in the gaseous mixture the conversion of indium and of a chalcogen into an indium chalcogenide does not, or at least only to a non-relevant extent, take place until the gaseous mixture reaches the reaction zone. Advantageously, the gaseous mixture is kept at a temperature between 30°C and 240°C, preferably at a temperature between 40°C and 210°C, and even more preferably at a temperature between 50°C and 200°C, until it reaches the reaction zone.

In a preferred embodiment an indium comprising precursor gas is premixed with a chalcogen comprising precursor gas and a carrier gas and the resulting mixture is delivered as gaseous mixture into the reaction zone. Advantageously, a gaseous component already contained in the indium and/or the chalcogen comprising precursor gas is used as carrier gas, so that no further carrier gas has to be added in order to obtain the desired gaseous mixture. For example an inert gas like nitrogen or argon contained in one of the precursor gases can be used as carrier gas.

Advantageously, at least one of the precursor gases comprises a stabilizing adduct group. For the purpose of the present invention, a stabilizing adduct group means an adduct group that stabilizes the gaseous mixture in such that the conversion of the precursor gases into indium chalcogenide is suppressed until the gaseous mixture reaches the reaction zone. Said stabilizing adduct group is preferably based on an element selected from the group consisting of sulphur, oxygen and electron donating nitrogen. Electron donating nitrogen based adduct groups are e.g. amine comprising compounds. Moreover, chelating agents can be used as stabilizing adduct groups of the indium comprising precursor gas, for example tetramethylethylendiamine. Another example is the usage of 1,2-etanedithiol in or as a chalcogen comprising precursor gas, as it simultaneously stabilizes certain indium comprising precursor gases like precursor gases containing trimethylindium.

Instead of premixing precursor gases, it is also possible to form the gaseous mixture by mixing an indium comprising precursor gas with a chalcogen comprising precursor gas and a carrier gas close to or in the reaction zone. Again, a gaseous component contained in the indium and/or the chalcogen comprising precursor gas is preferably used as carrier gas.

According to a preferred embodiment of the invention, in both cases, precursor gases premixed or not, at least one precursor gas is provided via at least one distribution head. Such distribution heads allow a controlled gas flow and are per se known from methods and apparatus of chemical vapour deposition. Preferably, temperature controlled distribution heads are used, which make it possible to improve uniformity of the deposited layer. As already discussed above, the substrate is advantageously moved during the deposition of the indium chalcogenide. Preferably, the substrate is moved relatively to the at least one distribution head or vice versa.

In a preferred embodiment of the method according to the invention an at atmospheric ambient pressure volatile chalcogen compound, preferably a sulphur compound and especially preferably a hydrogen sulphide or an organosulphur compound, is used as gaseous chalcogen source. Organosulphur compounds are for example alkyl sulphides. Also an ethanethiol, particularly 1,2-ethanedithiol, may be used as sulphur source. Particularly, sulphur sources being solid at room temperature might be advantageous against the background of maintenance and handling aspects. Obviously, different gaseous chalcogen sources can be mixed.

In both cases, precursor gases premixed or not, the usage of an indium comprising precursor gas containing trimethylindium and nitrogen carrier gas in combination with a chalcogenide comprising precursor gas containing hydrogen sulphide diluted into argon carrier gas has proven itself.

In one embodiment of the method according to the invention the indium chalcogenide layer, preferably an indium sulphide layer, is deposited as buffer layer of a solar cell.

In a preferred embodiment a metal layer, preferably a molybdenum layer, and subsequently an absorber layer, preferably an absorber layer comprising a compound represented by the formula Cu(In,Ga)(S,Se)₂ - or more precisely Cu(In₁₋ₐGaₐ) (S_{b},Se_{1-b})₂, where 0 ≤ a,b ≤ 1 -, are deposited onto the substrate before the indium chalcogenide is deposited onto the surface of the substrate. This, for example, allows a fabrication of CIS or CIGS solar cells at industrial scale and favourable cost. In connection with this embodiment the deposition of indium sulphide as indium chalcogenide is especially preferred.

The solar cell according to the invention is based on the concept of forming a buffer layer by chemical vapour deposition of an indium chalcogenide at approximately atmospheric ambient pressure. In this way thin film solar cells of reduced complexity can be provided.

In a preferred embodiment of the solar cell according to the invention indium sulphide is used as indium chalcogenide.

The apparatus according to the invention comprises a reactor, into which substrates can be introduced, a gas inlet slot for feeding gases into the reactor, a transport device for moving the substrates through the reactor, and at least one premixing device for premixing an indium comprising precursor gas with a chalcogen comprising precursor gas. A gaseous mixture produced in the premixing device can be fed from the premixing device into the reactor via the gas inlet slot. The transport device can be realized by known transport systems, e.g. push or pull rod systems or a conveyor belt.

In an advantageous embodiment of said apparatus several gas inlet slots are provided, which are arranged in a distance from each other in a transport direction of the transport device. Preferably, the gas inlet slots are arranged such that with each gas inlet slot a further sublayer can be deposited. In this way several sublayers can comfortably be deposited on a substrate passing the several gas inlet slots.

Each gas inlet slot might be connected to the same premixing device or to a separate premixing device.

Advantageously, a laminar flow of the gaseous mixture from the gas inlet slots to the substrates can be realized.

In a preferred embodiment, the apparatus comprises at least one temperature control device for controlling the temperature of the gaseous mixture in at least one premixing device or at at least one gas inlet slot. The at least one control unit might be realized as open-loop control device or as closed-loop device, the latter one being connected to heating or cooling devices for the gaseous mixture or materials fed into the at least one premixing device.

In a preferred embodiment at least one coater head is provided as gas inlet slot. As mentioned above, such coater heads are known from chemical vapour deposition apparatus. Preferably, the at least one coater head is a temperature controlled coater head.

In yet another preferred embodiment the apparatus comprises a heating device for heating the substrates. In this way, substrates can be preheated outside of the apparatus and additionally heated within the apparatus to a temperature required in the reaction zone. Also it is possible to heat the substrates to the required temperature within the apparatus without any previous heating of the substrates. If instead the apparatus does not comprise any heating device, the substrates have to be heated before entering the apparatus in such that their temperature on entering the reaction zone is still high enough to enable the conversion of indium originating from the indium source and the chalcogen originating from the source of a chalcogen to an indium chalcogenide.

The invention will be explained in more detail below with reference to figures. Elements exercising essentially similar effects are, as far as this appears appropriate, marked with equal reference signs.
- Fig. 1: Schematic illustration of a first embodiment of the method according to the invention.
- Fig. 2: Schematic illustration of a second embodiment of the method according to the invention.
- Fig. 3: Schematic illustration of a first embodiment of the apparatus according to the invention simultaneously illustrating a third embodiment of the method ac- cording to the invention.
- Fig. 4: A second embodiment of the apparatus according to the invention in a schematic drawing and a fourth embodiment of the method according to the inven- tion.
- Fig. 5: Schematic illustration of a thin film solar cell according to the invention.

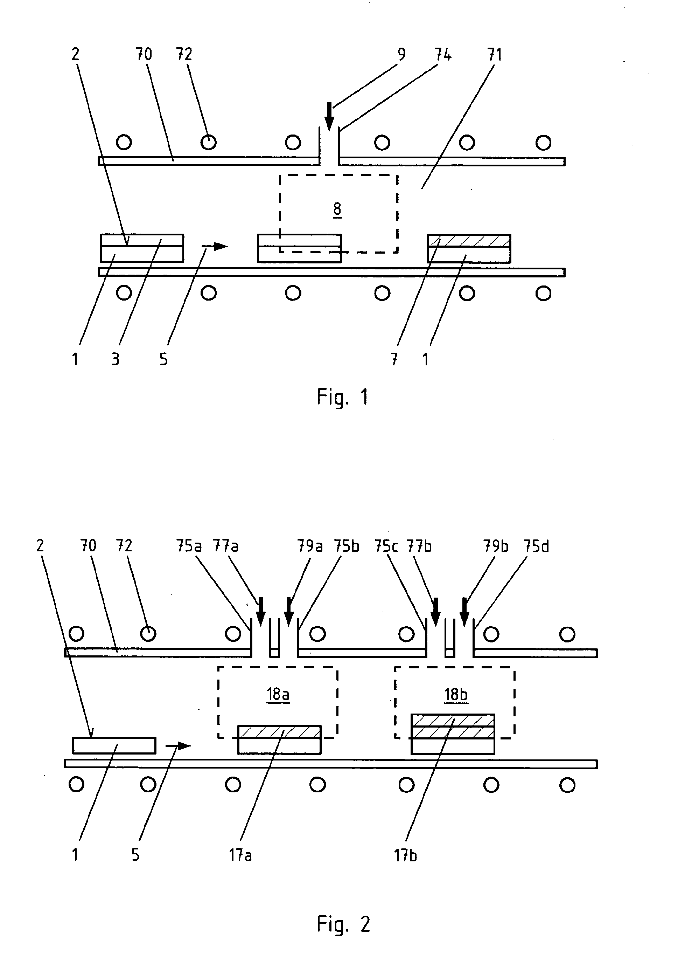

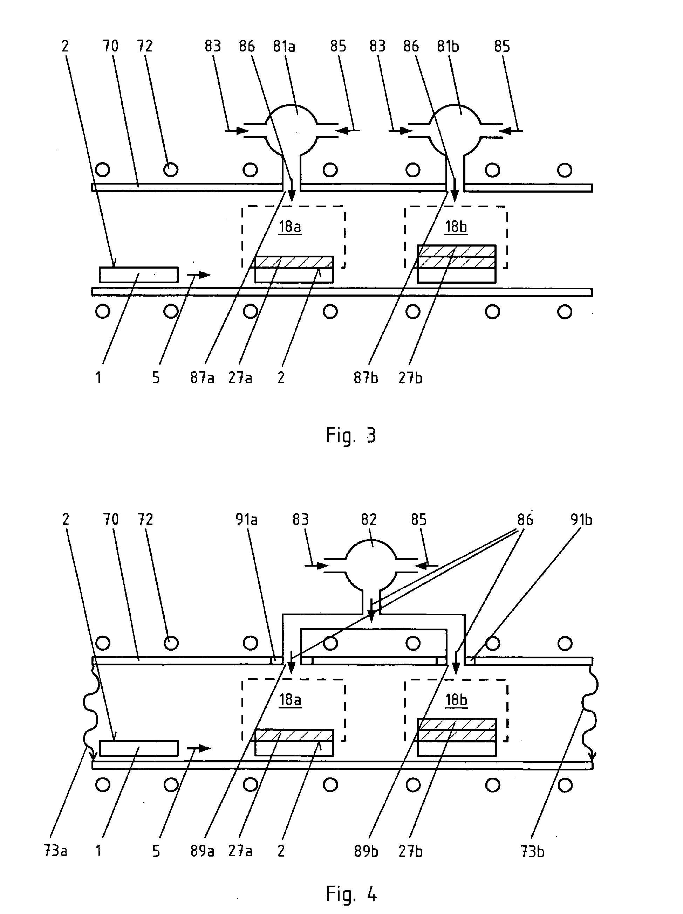

Figure 1 schematically shows a sequence of method steps performed in a reactor 70 and in this way illustrates a first embodiment of the method according to the invention. Substrates 1, onto a surface 2 of which an indium oxide 3 layer has been deposited, are introduced into a reactor 70. The reactor 70 comprises a heating device 72 for heating the substrates 1. In the embodiment of figure 1 an external heating device is used. It is however obvious to a person skilled in the art that also internal heating devices arranged in a chamber 71 of the reactor 70 can be used. The substrates 1 are heated by means of the heating device 72. Therefore, open ends of the reactor 70 can be provided, so that the substrates 1 can easily be transported into and through the reactor as indicated by the direction of substrate transport 5. At the open ends of the reactors depicted in figures 1 to 4, gas locks, particularly gas curtains, can be provided in order to prevent intrusion of contaminations into the reactor 70. Examples of such gas locks 73a, 73b are schematically indicated in figure 4.

In the embodiments illustrated in figures 1 to 4, said substrate transport is realized by means of a per se known transport device, e.g. a pull or push rod system or a conveyer-belt, which is not depicted in the figures for the purpose of enhanced clarity. With the help of said transport device the substrates 1 can be transported through the reactor 70. In case of figure 1 the substrate 1 carrying the indium oxide layer 3 is transported from the left to the right side by means of the transport device. In this way the substrate 1 reaches a reaction zone 8 and is arranged in it for a certain time. During this time also the indium oxide 3 deposited onto the substrate 1 is arranged in the reaction zone 8 and serves as indium source. Moreover, a gaseous source of a chalcogen, in the embodiment depicted in figure 1 represented by a mixture 9 of hydrogen sulphide and argon gas used as carrier gas, is fed into the reaction zone 8 via a gas inlet 74. As consequence of the heating of the substrate 1, in the reaction zone 8 indium originating from the indium oxide 3 and sulphur originating from the hydrogen sulphide argon mixture 9 fed into the reaction zone are converted at approximately atmospheric ambient pressure into indium sulphide, so that as a result an indium sulphide 7 layer is comfortably deposited on the surface 2 of the substrate 1.

Figure 2 schematically illustrates a further embodiment of the method according to the invention. According to this embodiment, substrates 1 without any indium source deposited thereon are introduced into the reactor 70. These substrates 1 are again transported by a not depicted transport device in the direction of transport 5 into a first reaction zone 18a. By means of a gas inlet 75a trimethylindium and nitrogen 77a are fed as an indium comprising precursor gas and as a carrier gas into the first reaction zone 18a. By means of a gas inlet 75b also a mixture 79a of hydrogen sulphide and argon gas as a carrier gas is fed into the first reaction zone 18a. In doing so, the mixture 79a of hydrogen sulphide and argon represents a chalcogen comprising precursor gas. In the first reaction zone 18a, said indium comprising precursor gas formed by the mixture 77a of trimethylindium and nitrogen gas is mixed with the mixture 79a of hydrogen sulphide and argon, so that a gaseous mixture comprising the carrier gases nitrogen and argon, trimethylindium as an indium source and hydrogen sulphide as chalcogen source is provided in the first reaction zone 18a. Due to the heating of the substrate, indium originating from the mixture 77a of trimethylindium and nitrogen and sulphur originating from the mixture 79b of hydrogen sulphide and argon carrier gas are converted into indium sulphide and deposited onto the surface 2 of the substrate 1 as indium sulphide sublayer.

Further on, the substrate 1 carrying the indium sulphide sublayer 18a is transported into a second reaction zone 18b. All transport of the substrates 1 is preferably done continuously. This means that the substrates 1 are continuously moved relatively to the reactor 70.

Via gas inlets 75c and 75d again a mixture 77b of trimethylindium and the carrier gas nitrogen and a mixture 79b of hydrogen sulphide and argon gas as carrier gas are fed into the second reaction zone 18b. Therefore, by analogy with the indium sulphide sublayer 17a in the first reaction zone 18a, a further indium sulphide sublayer 17b is deposited onto the previously deposited indium sulphide sublayer 17a. Both indium sulphide sublayers 17a, 17b form together the final indium sulphide layer. Such a sequential deposition of indium sulphide sublayers makes it possible to produce indium sulphide layers of enhanced homogeneity. Furthermore, thickness of the indium sulphide layer can be quite easily controlled. In principle, any number of indium sulphide sublayers can be deposited by elongating the reactor 70 and providing additional gas inlets.

Figure 3 schematically illustrates a further embodiment of the method according to the invention and simultaneously a first embodiment of an apparatus according to the invention. The apparatus schematically depicted in figure 3 differs from the one of figure 2 in such that two premixing devices 81a, 81b are provided. A mixture 83 of trimethylindium and nitrogen forming together an indium comprising precursor gas and a mixture 85 of 1,2-ethanedithiol and nitrogen are fed into each of said premixing devices 81a, 81b. In doing so, the mixture 85 of 1,2-ethanedithiol and nitrogen represents a chalcogen comprising precursor gas. Said materials are premixed in the premixing devices 81a, 81b. The resulting gaseous mixtures 86 are fed into the reactor 70 via inlet slots 87a and 87b. Within the reactor 70 the gaseous mixtures are fed into the first 18a and second reaction zone 18b, respectively. In the reaction zones 18a, 18b indium and sulphide comprised in the gaseous mixture are converted to indium sulphide. By analogy with the embodiment of figure 2, in the first reaction zone 18a an indium sulphide sublayer 27a is deposited onto the surface 2 of the substrate 1, and in the second reaction zone 18b a further indium sulphide sublayer 27b is deposited onto the previously deposited indium sulphide sublayer 27a.

Under atmospheric pressure trimethylindium is solid at room temperature. In order to provide the indium comprising precursor gas, a trimethylindium source is therefore preferably heated to a temperature between 25°C and 75°C, so that the material partly sublimes. Further on, nitrogen is preferably provided as carrier gas for trimethylindium vapour. Flowing above the trimethylindium source it carries away trimethylindium vapour and delivers it into the premixing devices. In this way growth rates of the indium sulphide layer can be improved.

In the embodiment of figure 3 and also in the embodiment of figure 4 described below 1,2-ethanedithiol is premixed with trimethylindium. Obviously, these materials can also be used in the embodiments of figure 1 and 2 and vice versa. Apparently, also other material combinations are possible. In praxi also the use of trimethylindium with a nitrogen carrier gas as indium comprising precursor gas in combination with hydrogen sulphide diluted into argon has proven itself. Therein, hydrogen sulphide diluted into argon represents the chalcogen comprising precursor gas. Such a gaseous mixture is preferably kept at a temperature of about 50°C until it is fed into the reaction zone.

Figure 4 shows in a schematic illustration a further embodiment of the apparatus according to the invention and illustrates simultaneously a further embodiment of the method according to the invention. The apparatus differs from the one known from figure 3 in such that only one premixing device 82 is provided instead of two. Furthermore, in contrast to figure 3 the gas inlets are realized by means of temperature controlled distribution heads 91a, 91b. The gaseous mixture 86 is consequently fed from the premixing device 82 into the reactor 70 and in the first and second reaction zones 18a, 18b via openings 89a, 89b of said temperature controlled distribution heads 91a, 91b. As a result, the precursor gases being part of the gaseous mixture 86 are provided via the distribution heads 91a, 91b.

By providing one premixing device 82 for several, in this embodiment two, distribution heads 91a, 91b or gas inlets in general, complexity of the apparatus can be reduced. Apparently, the number of premixing devices and the number of gas inlets or distribution heads each premixing device supplies with the gaseous mixture can be adapted to individual needs.

Distribution heads, and particularly temperature controlled distribution heads, can obviously also be provided instead of gas inlets in the embodiments of figures 1 to 3. Temperature controlled distribution heads are, however, particularly advantageous in the embodiments of figures 3 and 4 as they facilitate the temperature control of the gaseous mixture 86.

All the apparatus depicted in figures 1 to 4 can easily be integrated in inline production lines, so that a cost efficient deposition of indium chalcogenide layers at an industrial scale becomes possible. In particular, thin film solar cells can be advantageously produced using one of the methods and one of the apparatus according to the depicted embodiments.

In each of the embodiments of the apparatus depicted in figures 1 to 4 the heating device 72 can be omitted, if the substrates 1 are preheated outside the reactor 70 in such that on reaching the reaction zone 8; 18a, 18b their temperature is still high enough to enable the conversion of indium originating from the indium source and the chalcogen originating from the source of a chalcogen to an indium chalcogenide.

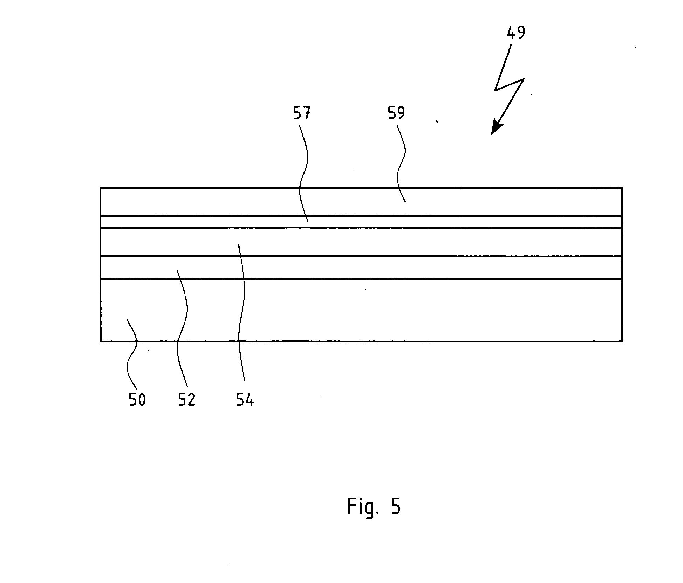

Figure 5 schematically illustrates a solar cell 49 according to the invention. It comprises a glass substrate 50 covered by a molybdenum layer 52. A CIGS layer 54 serving as absorber layer is formed on said molybdenum layer. Upon this CIGS layer 54 an indium sulphide layer 57 formed by chemical vapour deposition at approximately atmospheric ambient pressure is provided as buffer layer. A zinc oxide layer 59 is provided on the indium sulphide layer 57 as a transparent conducting layer.

The solar cell 49 can be manufactured using one of the methods and apparatus illustrated in figures 1 to 4. The substrate 1 in figures 1 to 4 would then be formed by the glass substrate 50, the molybdenum layer 52 and the CIGS layer 54. The surface 2 onto which the indium sulphide is deposited, would then be an upper surface of the CIGS layer 54. This makes clear again, that for the purpose of the present invention substrate means anything an indium chalcogenide layer can be deposited on. In particular it can mean a glass substrate carrying a metal back contact layer and an absorber layer of a thin film solar cell.

### List of Reference numbers

- 1: Substrate
- 2: Surface of substrate
- 3: Indium oxide
- 5: Direction of substrate transport
- 7: Indium sulphide
- 8: Reaction zone
- 9: Hydrogen sulphide and argon
- 17a: Indium sulphide sublayer
- 17b: Indium sulphide sublayer
- 18a: First reaction zone
- 18b: Second reaction zone
- 27a: Indium sulphide sublayer
- 27b: Indium sulphide sublayer
- 49: Solar cell
- 50: Glass substrate
- 52: Molybdenum layer
- 54: CIGS layer
- 57: Indium sulphide layer
- 59: Zinc oxide layer
- 70: Reactor
- 71: Chamber
- 72: Heating device
- 73a: Gas lock
- 73b: Gas lock
- 74: Gas inlet
- 75a: Gas inlet
- 75b: Gas inlet
- 75c: Gas inlet
- 75d: Gas inlet
- 77a: Trimethylindium and nitrogen
- 77b: Trimethylindium and nitrogen
- 79a: Hydrogen sulphide and argon
- 79b: Hydrogen sulphide and argon
- 81a: Premixing device
- 81b: Premixing device
- 83: Trimethylindium and nitrogen
- 85: 1,2-ethanedithiol and nitrogen
- 86: Gaseous mixture
- 87a: Inlet slot
- 87b: Inlet slot
- 89a: Opening of distribution head
- 89b: Opening of distribution head
- 91a: Temperature controlled distribution head
- 91b: Temperature controlled distribution head

## Claims

1. Method for depositing a layer of an indium chalcogenide (7;
17a, 17b; 27a, 27b) onto a substrate (1), the method comprising the steps of
- providing an indium source (3; 77a, 77b; 83) in a reaction zone (8; 18a, 18b),
- providing a gaseous source (9; 79a, 79b; 85) of a chalcogen in the reaction zone (8; 18a, 18b),
- heating the substrate (1), and
- thereby in the reaction zone (8; 18a, 18b) converting at a pressure of approximately atmospheric ambient pressure indium originating from the indium source (3; 77a, 77b; 83) and the chalcogen originating from the source (9; 79a, 79b; 85) of a chalcogen to an indium chalcogenide (7; 17a, 17b; 27a, 27b) being deposited onto a surface (2) of the substrate (1).

2. Method according to claim 1, wherein
the indium source (3) is provided in the reaction zone (8) by depositing an indium comprising compound (3), preferably indium oxide (3), onto the surface (2) of the substrate (1) and arranging the substrate (1) at least partly in the reaction zone (8).

3. Method according to claim 1, wherein
a gaseous mixture (86) comprising a carrier gas (79a, 79b; 85), the indium source (77a, 77b; 83) and the chalcogen source (79a, 79b; 85) is provided in the reaction zone (18a, 18b).

4. Method according to claim 3, wherein
an indium comprising precursor gas (83) is premixed with a chalcogen comprising precursor gas (85) and a carrier gas (85) and the resulting mixture (86) is delivered as gaseous mixture (86) into the reaction zone (18a, 18b), whilst a gaseous component contained in the indium (83) and/or the chalcogen comprising precursor gas (85) is preferably used as carrier gas (85).

5. Method according to claim 4, wherein
at least one of the precursor gases (85) comprises a stabilizing adduct group, the stabilizing adduct group being preferably based on an element selected from the group consisting of sulphur, oxygen and electron donating nitrogen.

6. Method according to claim 3, wherein
the gaseous mixture is formed by mixing an indium comprising precursor gas (77a, 77b) with a chalcogen comprising precursor gas (79a, 79b) and a carrier gas (79a, 79b) close to or in the reaction zone (18a, 18b), whilst a gaseous component contained in the indium (77a, 77b) and/or the chalcogen comprising precursor gas (79a, 79b) is preferably used as carrier gas.

7. Method according to one of claims 3 to 6, wherein
at least one precursor gas (83, 85) is provided via at least one distribution head (91a, 91b), preferably via a temperature controlled distribution head (91a, 91b).

8. Method according to any of the preceding claims, wherein the indium chalcogenide layer (7; 17a, 17b; 27a, 27b), preferably an indium sulphide layer (7; 17a, 17b; 27a, 27b), is deposited as buffer layer (57) of a solar cell (49).

9. Method according to any of claims 1 or 3 to 8, wherein
at least one at atmospheric pressure volatile indium compound (77a, 77b; 83) is used as indium source, preferably an indium compound having the formula InCₓH_{y}, where x ranges from 3 to 20 and y ranges from 9 to 39.

10. Method according to claim 9, wherein
at least one indium alkyl compound (83), preferably trimethylindium, is used as indium source.

11. Method according to claim 10, wherein
an indium compound is used as indium source which comprises at least one alkyl group and at least one further functional group selected from the group consisting of a hydrogen group, a halide group and an acetate group.

12. Method according to any of the preceding claims, wherein an at atmospheric ambient pressure volatile chalcogen compound (9; 79a, 79b; 85), preferably a sulphur compound (9; 79a, 79b; 85) and especially preferably a hydrogen sulphide (9; 79a, 79b) or an organosulphur compound (85), is used as gaseous source of a chalcogen.

13. Method according to any of the preceding claims, wherein
a metal layer (52), preferably a molybdenum layer (52), and subsequently an absorber layer (54), preferably an absorber layer comprising a compound represented by the formula Cu(In,Ga)(S,Se)₂, are deposited onto the substrate (50) before the indium chalcogenide (7; 17a, 17b; 27a, 27b) is deposited onto the surface (2) of the substrate (1).

14. Solar cell (49) comprising
an absorber layer (54) formed by a compound semiconductor (54) and a buffer layer (57),
**characterized in that**
the buffer layer (57) is formed by chemical vapour deposition of an indium chalcogenide (7; 17a, 17b; 27a, 27b) at approximately atmospheric ambient pressure.

15. Solar cell (49) according to claim 14, wherein the indium chalcogenide layer (7; 17a, 17b, 27a, 27b) is formed using the method according to any of claims 1 to 13.

16. Apparatus for carrying out the method according to any of claims 1 to 13, comprising
- a reactor (70), into which substrates (1) can be introduced,
- a gas inlet slot (87a, 87b) for feeding gases (86) into the reactor (70), and
- a transport device for moving the substrates (1) through the reactor (70),
**characterized in that**
at least one premixing device (81a, 81b; 82) for prexmixing an indium comprising precursor gas (83) with a chalcogen comprising precursor gas (85) is provided and that a gaseous mixture (86) can be fed from the at least one premixing device (81a, 81b; 82) into the reactor (70) via the gas inlet slot (87a, 87b).

17. Apparatus according to claim 16, wherein several gas inlet slots (87a, 87b) are provided, which are arranged in a distance from each other in a transport direction (5) of the transport device.

18. Apparatus according to any of claims 16 to 18, wherein the reactor (70) comprises one or more openings for introducing substrates (1) into or discharging substrates from the reactor (70), and that a gas lock (73a, 73b) is provided at at least one of said openings.

19. Apparatus according to any of claims 16 to 18, wherein a heating device (72) for heating the substrates (1) is provided.

## Amended claims

### Amended claims in accordance with Rule 137(2) EPC.

**1.** Method for depositing a layer of an indium chalcogenide (7; 17a, 17b; 27a, 27b) onto a substrate (1), the method comprising the steps of
- providing an indium source (3; 77a, 77b; 83) in a reaction zone (8; 18a, 18b),
- providing a gaseous source (9; 79a, 79b; 85) of a chalcogen in the reaction zone (8; 18a, 18b),
- heating the substrate (1), and
- thereby in the reaction zone (8; 18a, 18b) converting at a pressure of approximately atmospheric ambient pressure indium originating from the indium source (3; 77a, 77b; 83) and the chalcogen originating from the source (9; 79a, 79b; 85) of a chalcogen to an indium chalcogenide (7; 17a, 17b; 27a, 27b) being deposited onto a surface (2) of the substrate (1), **characterized in that**
- a gaseous mixture (86) comprising a carrier gas (79a, 79b; 85), the indium source (77a, 77b; 83) and the chalcogen source (79a, 79b; 85) is provided in the reaction zone (18a, 18b).

**2.** Method according to claim 1, wherein
an indium comprising precursor gas (83) is premixed with a chalcogen comprising precursor gas (85) and a carrier gas (85) and the resulting mixture (86) is delivered as gaseous mixture (86) into the reaction zone (18a, 18b), whilst a gaseous component contained in the indium (83) and/or the chalcogen comprising precursor gas (85) is preferably used as carrier gas (85).

**3.** Method according to claim 2, wherein
at least one of the precursor gases (85) comprises a stabilizing adduct group, the stabilizing adduct group being preferably based on an element selected from the group consisting of sulphur, oxygen and electron donating nitrogen.

**4.** Method according to claim 1, wherein
the gaseous mixture is formed by mixing an indium comprising precursor gas (77a, 77b) with a chalcogen comprising precursor gas (79a, 79b) and a carrier gas (79a, 79b) close to or in the reaction zone (18a, 18b), whilst a gaseous component contained in the indium (77a, 77b) and/or the chalcogen comprising precursor gas (79a, 79b) is preferably used as carrier gas.

**5.** Method according to one of claims 1 to 3, wherein
at least one precursor gas (83, 85) is provided via at least one distribution head (91a, 91b), preferably via a temperature controlled distribution head (91a, 91b).

**6.** Method according to any of the preceding claims, wherein the indium chalcogenide layer (7; 17a, 17b; 27a, 27b), preferably an indium sulphide layer (7; 17a, 17b; 27a, 27b), is deposited as buffer layer (57) of a solar cell (49).

**7.** Method according to any of claims 1 to 6, wherein
at least one at atmospheric pressure volatile indium compound (77a, 77b; 83) is used as indium source, preferably an indium compound having the formula InCₓH_{y}, where x ranges from 3 to 20 and y ranges from 9 to 39.

**8.** Method according to claim 7, wherein
at least one indium alkyl compound (83), preferably trime-thylindium, is used as indium source.

**9.** Method according to claim 8, wherein
an indium compound is used as indium source which comprises at least one alkyl group and at least one further functional group selected from the group consisting of a hydrogen group, a halide group and an acetate group.

**10.** Method according to any of the preceding claims, wherein an at atmospheric ambient pressure volatile chalcogen compound (9; 79a, 79b; 85), preferably a sulphur compound (9; 79a, 79b; 85) and especially preferably a hydrogen sulphide (9; 79a, 79b) or an organosulphur compound (85), is used as gaseous source of a chalcogen.

**11.** Method according to any of the preceding claims, wherein
a metal layer (52), preferably a molybdenum layer (52), and subsequently an absorber layer (54), preferably an absorber layer comprising a compound represented by the formula Cu(In,Ga) (S,Se)₂, are deposited onto the substrate (50) before the indium chalcogenide (7; 17a, 17b; 27a, 27b) is deposited onto the surface (2) of the substrate (1).

**12.** Apparatus for carrying out the method according to any of claims 1 to 11, comprising
- a reactor (70), into which substrates (1) can be introduced,
- a gas inlet slot (87a, 87b) for feeding gases (86) into the reactor (70), and
- a transport device for moving the substrates (1) through the reactor (70),
**characterized in that**
at least one premixing device (81a, 81b; 82) for prexmixing an indium comprising precursor gas (83) with a chalcogen comprising precursor gas (85) is provided and that a gaseous mixture (86) can be fed from the at least one premixing device (81a, 81b; 82) into the reactor (70) via the gas inlet slot (87a, 87b).

**13.** Apparatus according to claim 12, wherein
several gas inlet slots (87a, 87b) are provided, which are arranged in a distance from each other in a transport direction (5) of the transport device.

**14.** Apparatus according to any of claims 12 to 13, wherein the reactor (70) comprises one or more openings for introducing substrates (1) into or discharging substrates from the reactor (70), and that a gas lock (73a, 73b) is provided at at least one of said openings.

**15.** Apparatus according to any of claims 12 to 14, wherein a heating device (72) for heating the substrates (1) is provided.
